# EUROPEAN PATENT APPLICATION

(11) **EP 4 592 993 A1**
(43) Date of publication of application: **30.07.2025**
(21) Application number: 24162203.4
(22) Date of filing: 07.03.2024
(51) Int. Cl.: G09F 9/302

(54) **AN ASSEMBLING FRAME FOR AN LED DISPLAY**

(30) Priority: 29.01.2024 CN 202410121070
(71) Applicant: Shenzhen Chip Optech Co. Ltd., Shenzhen, Guangdong 518108 (CN)
(72) Inventor: Wu, Xiaogang, Shenzhen, Guangdong (CN)
(74) Representative: Tahtadjiev, Konstantin

(57) **Abstract**

The present invention relates to an assembling frame for an LED display, which has a lateral width and a vertical height, wherein the sizes of the lateral width and the vertical height are not the same, and a number of the assembling frames are assembled together to form a large LED display, and a number of the assembling frames are assembled in a lateral assembling manner or a lateral assembling manner to form the large LED display.

## Description

### BACKGROUND OF THE PRESENT INVENTION

### FIELD OF INVENTION

The present invention relates to an assembling frame, and particularly to an assembling frame that can assemble to form a large LED display screen in a lateral assembling manner or a vertical assembling manner.

### DESCRIPTION OF RELATED ARTS

As a device capable of displaying images, LED display screens have been commonly used in people's lives.

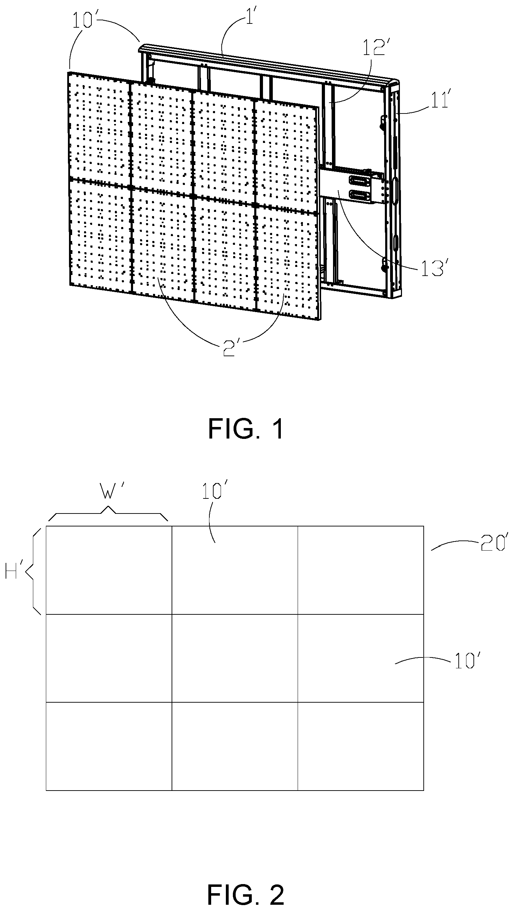

As shown in FIG. 1, a structural schematic view of a conventional LED display screen is illustrated, and the conventional LED display screen 10' generally includes a container 1' and LED display modules 2', wherein the container 1' includes an outer frame body 11', structural beams 12' and a power container 13', wherein the structural beam 12' is connected to the outer frame body 11', and the power container 13' is set in a central position of the outer frame body 11', and the LED display module 2' is assembled at the front end of the container 1', and when working, the LED display module 2' is energized to emit light and display image information outwardly.

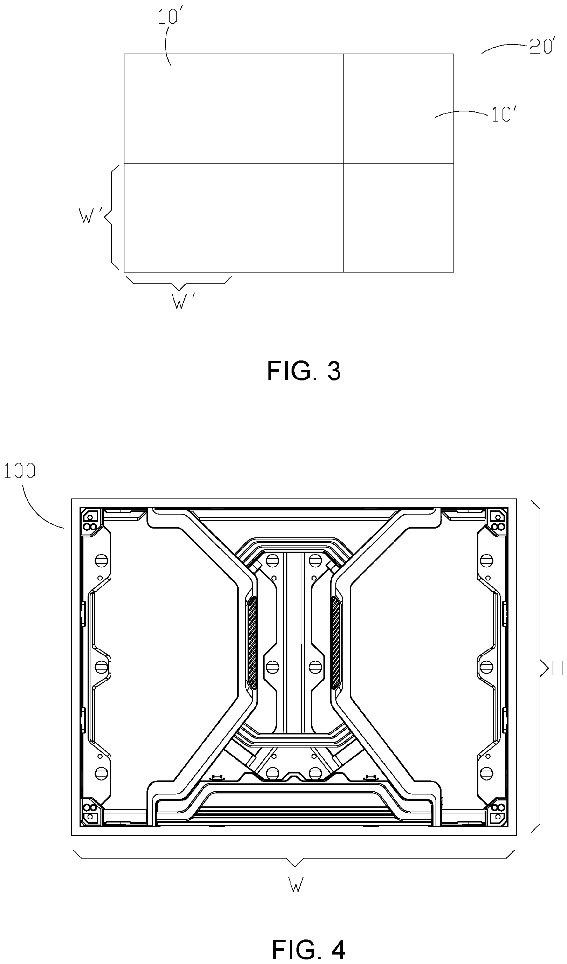

In practice, as shown in FIGS. 2 and 3, several LED displays 10' are assembled together to form a large LED display 20' to display image information outwardly.

The conventional LED display 10' is generally rectangular or square in shape, and the conventional LED display 10' has a width W' and a height H'.

When the LED display 10' is rectangular and when the lateral N1' LED displays 10' and the vertical N2' LED displays 10' are assembled together, the width of large LED display 20 can only be W'* N1' and the height of the large LED display 20' can only be H'* N2'.

When the LED display 10' is square, the width W' of the LED display is equal to the height H', and when the lateral N1' LED displays 10' and the vertical N2' LED displays 10' are assembled together, the width of the large LED display 20' can only be W'* N1', and the height of the large LED display 20' can only be W'* N2' .

As described above, the large LED display 20' formed by assembling the conventional LED displays 10' has a single form size, and the size of the large LED display 20' can only be a single geometric multiple size of the LED display 10'.

For example, when the width W' of the LED display 10 for 700CM and the height H' of the LED display 10 for 500CM, the width of the large LED display 20 can only be 700CM * N1' and the height of large LED display 20 can only be 500CM * N2'.

However, in practice, requirements on the size of the large LED display 20 requirements are varied, the traditional LED display 10' has been unable to meet the people requirements, and the is the main drawbacks of the prior art.

### SUMMARY OF THE PRESENT INVENTION

The present invention provides an LED display assembling frame, wherein the assembling frame has different sizes for lateral width and vertical height, and several assembling frames can be assembled laterally or vertically to form a large LED display, and different overall sizes of the large LED display can be assembled in different assembling manner. At the same time, the user can decide the assembling quantity of the assembling frame according to the needs, so as to achieve the purpose of assembling various large LED display screens of different overall sizes.

The present invention provides a LED display assembling frame, the back of the assembling frame is provided with a handle unit, so that in the assembling or front and back operation, the user holds the handle unit to achieve the purpose of conveniently assembling the large LED display as well as conveniently carrying out the front and back operation.

The present invention provides a LED display assembling frame, the assembling frame also includes a lower component container, wherein the lower component container is directly integrated into the outer frame body on the bottom border, in other words, the lower component container and the outer frame body are a whole, so that the structure is simple thereof and facilitated the production, and at the same time, the structure is conducive thereof to the heat dissipation of the display.

In order to accomplish the above objects, the present invention provides an assembling frame for an LED display having a lateral width W and a vertical height H, wherein the lateral width W and the vertical height H have different sizes, wherein the assembling frame is assembled with an LED display module on the front side, and the LED display module is energized to emit light and display image information, wherein several of the assembling frames are assembled together to form a large LED display screen, wherein the large LED display comprises N1 of the assembling frames in lateral, and the number of N1 of the assembling frames in lateral is more than 2,wherein the large LED display comprises N2 of the assembling frames in vertical, and the number of N2 of the assembling frames in vertical is more than 2, wherein the several of the assembling frames are formed into the large LED display in a lateral assembling manner or a vertical assembling manner, wherein when the several of the assembling frames are formed into the large LED display in the lateral assembling manner, the width of the large LED display is the width W times the number of the assembling frames in lateral, and the height of the large LED display is the vertical height H times the number of the assembling frames in vertical, wherein when the several of the assembling frames are formed into the large LED display in the vertical assembling manner, the width of the large LED display is the height H times the number of the assembling frames in lateral, and the height of the large LED display is the lateral width W times the number of the assembling frames in vertical.

### BRIEF DESCRIPTION OF THE DRAWINGS

FIG. 1 is a structural schematic view of conventional LED display.
FIG. 2 is an assembling schematic view of conventional rectangular LED displays.
FIG. 3 is an assembling schematic view of conventional rectangular LED displays.
FIG. 4 is a front view of the present invention.
FIG. 5 is a schematic view in lateral assembling manner of the present invention.
FIG. 6 is a schematic view in vertical assembling manner of the present invention.
FIG. 7 is a perspective view of the present invention.
FIG. 8 is another perspective view of the present invention.
FIG. 9 is an assembling schematic view of LED displays of the present invention.
FIG. 10 is a schematic view of a first vertical distance and a second vertical distance of the present invention.
FIG. 11 is a schematic view of a left handle and a right handle of the present invention.
FIG. 12 is a schematic view of a lower component container of the present invention.
FIG. 13 is another schematic view of a lower component container of the present invention.
FIG. 14 is a section structural view of a lower component container of the present invention.

### DETAILED DESCRIPTION OF THE PREFERRED EMBODIMENT

As shown in FIGS. 4 to 14, and in particular as shown in FIG. 4, an assembling frame 100 of an LED display screen has a lateral width W and a vertical height H, wherein the lateral width W and the vertical height H are not the same, in other words, the assembling frame 100 is not square.

The assembling frame 100 is assembled with an LED display module 200 on the front side, wherein the LED display module 200 is energized to emit light and display image information.

Several of the assembling frames 100 are assembled together to form a large LED display 300, the large LED display 300 includes N1 of lateral assembling frames 100, N1≥2, in other words, the number of N1 of laterally assembling frames 100 is ≥2, as well as the large LED display 300 includes N2 of vertical assembling frames 100, N2≥2, in other words, the number of N2 vertical assembling frames 100 is ≥2.

Several of the assembling frames 100 are assembled laterally or vertically to form the large LED display 300.

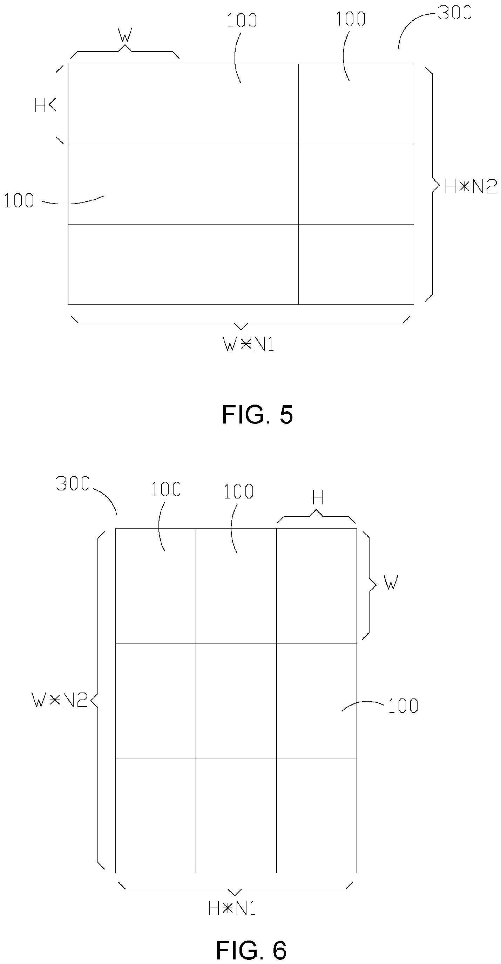

As shown in FIG. 5, when several of the assembling frames 100 are formed into the large LED display 300 in the lateral assembling manner, the width of the large LED display 300 has the following sizes as: the lateral width W * the number of N1 of the assembling frames 100 in lateral, namely W * N1, and the height of the large LED display 300 has the following sizes as: the vertical height H * the number of N2 of the assembling frames 100 in vertical, namely H * N2.

As shown in FIG. 6, when several of the assembling frames 100 are assembled in the vertical direction to form the large LED display 300, the width of the large LED display 300 has the following sizes as: the vertical height H * the number of N1 of the assembling frames 100 in lateral, namely H * N1, and the height of the large LED display 300 has the following sizes as: the lateral width W * the number of N2 of the assembling frames 100 in vertical, namely W * N2.

When detaching one or more of the assembling frames 100 from the large LED display 300 or when assembling one or more of the assembling frames 100 in the large LED display 300, a front operation manner or a back operation manner is capable.

Wherein the front operation manner is to detach or assemble the assembling frame 100 from the front side of the large LED display 300.

Wherein the backside operation manner is to detach or assemble the assembling frame 100 from the back side of the large LED display 300.

The assembling frame 100 of the present invention has different sizes of the lateral width W and the vertical height H, at the same time, several assembling frames 100 can be assembled laterally or vertically to form the large LED display 300, and according to the different assembling manners of the assembling frame 100, different overall sizes of the large LED display 300 can be assembled, in addition, in the practical assembling, the user can decide the number of N1 and N2 according to the need, so as to achieve the purpose of assembling a variety of different overall sizes of the large LED display screen and to facilitate the use of people.

In order to facilitate the user to assemble and disassemble, the back of the LED container is equipped with assembling handles, so as to facilitate the user to assemble, move, maintenance and repair through the assembling handles.

The assembling frame 100 of the present invention has been provided the following assembling handles to fit to the assembling manner and the front and back operation manners, in order to apply to the lateral assembling and vertical assembling manners and the front and back operation manners, as described below.

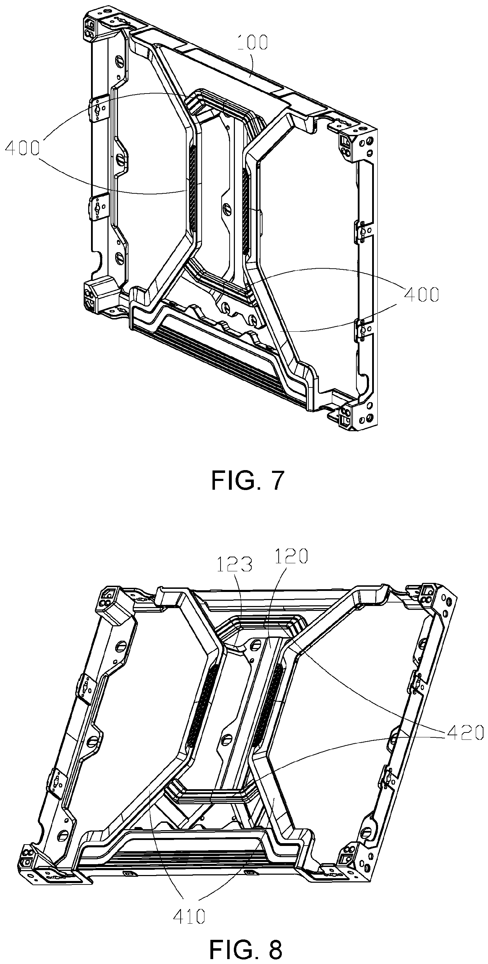

As shown in FIG. 7, the back of the assembling frame 100 is provided with a handle unit 400, and when assembling or operating the front and back, the user holds the handle unit 400 in his hand to achieve the purpose of facilitating the assembling of the large LED display 300 as well as facilitating the front and the back operation, and in practice, the user can achieve the detaching or assembling of one or several assembling frames 100 by the front operation manner or the back operation manner, so as to facilitate the repair and maintenance work later.

As shown in FIG. 8, the handle unit 400 includes a first handle portion 410 and a second handle portion 420.

The first handle portion 410 enables the operation of the lateral assembling manner and the back operation.

The second handle portion 420 enables operation of the vertical assembling manner and the front operation.

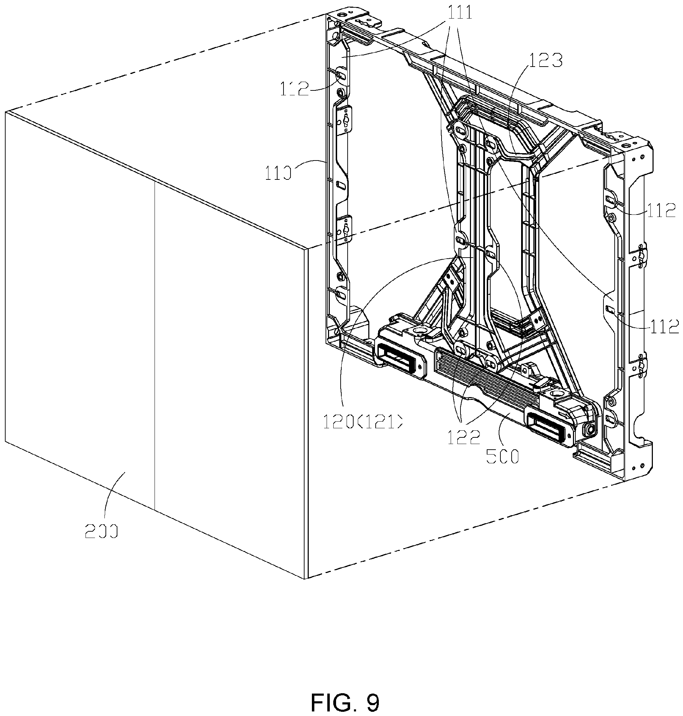

As shown in FIG. 9, in practice, the assembling frame 100 includes an outer frame body 110 having an LED module assembling surface 111, wherein the LED module assembling surface 111 is at the front end of the outer frame body 110, and the LED display module 200 is detachably assembled on the LED module assembling surface 111.

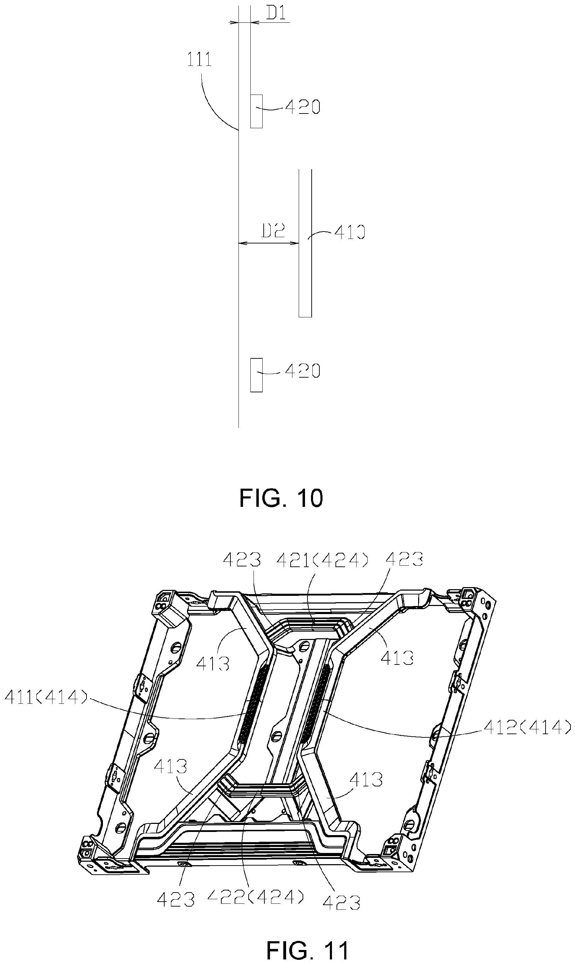

As shown in FIG. 10, the handle unit 400 is coupled to the outer frame body 110, wherein a first vertical distance D1 is between the first handle portion 410 and the LED module assembling surface 111, and a second vertical distance D2 is between the second handle portion 420 and the LED module assembling surface 111, and the first vertical distance D1 is greater than or equal to the second vertical distance D2, namely D1 ≥ D2.

Wherein when assembling in the lateral manner, the user holds the first handle portion 410 for operation, and when detaching or assembling in the back operation manner, the user stands at the back of the large LED display 300, and the user holds the first handle portion 410 for operation.

Wherein when the assembling operation in the vertical manner, the user holds the second handle portion 420 for operation, and when the detaching or assembling operation in the frontal operation manner, the LED display module 200 has to be detached from the front side of the assembling frame 100, and after that, the user stands on the front side of the large LED display 300 and put the hands of the user through the assembling frame 100, and the user holds the first handle portion 410 for operation.

As shown in FIGS. 7 to 9, in practice, the second handle portion 420 is connected to the first handle portion 410 to form the handle unit 400.

As shown in FIG. 11, in practice, the first handle portion 410 includes a left handle 411 and a right handle 412.

The left handle 411 as well as the right handle 412 both include a first connecting bar 413 and a first handle bar 414, wherein the first handle bar 414 is connected between two of the first connecting bars 413, and the first connecting bars 413 are tiltedly connected to that outer frame body 110.

The second handle portion 420 is connected between the left handle 411 and the right handle 412, and the second handle portion 420 includes an upper handle 421 and a lower handle 422, wherein the upper handle 421 and the lower handle 422 both include a second connecting bar 423 and a second handle bar 424, wherein the second handle bar 424 is connected between two of the second connecting bars 423, and the second connecting bars 423 are tiltedly connected to the first connecting bar 413.

As shown in FIGS. 8 to 9, in one embodiment, the assembling frame 100 further includes a module assembling plate 120 having an assembling surface 121 that overlaps with the LED module assembling surface 111.

The module assembling plate 120 is provided with several plate holes 122, and the outer frame body 110 is provided with several frame holes 112 at the front end of the outer frame body 110, wherein several of the plate holes 122 and several of the frame holes 112 are provided on the LED module assembling surface 111, and the LED display module 200 is detachably assembled on the LED module assembling surface 111 by several of the plate holes 122 and several of the frame holes 112.

In practice, the module assembling plate 120 is coupled to the handle unit 400 so that the module assembling plate 120 is suspended in the outer frame body 110, and the module assembling plate 120 is provided with several connecting claws 123, wherein one end of the connecting claws 123 is coupled to the module assembling plate 120 and the other end of the connecting claws 123 is coupled to the handle unit 400.

By the several connecting claws 123, the module assembling plate 120 is suspended at the central position of the outer frame body 110 to facilitate the assembling of the LED display module 200, so as to has the effect of simplifying the product structure and reducing the weight of the product.

As shown in FIGS. 9, 12 to 13, in practice, the assembling frame 100 further includes a lower component container 500 integrally disposed in the outer frame body 110, wherein the lower component container 500 is disposed on the bottom border of the outer frame body 110.

As shown in FIG. 1, the traditional LED display whose power supply container 13' is generally set in the center of the container in order to match the LED module, so the power supply container 13' needs to be fixed by several structural beams 12', so that the structure is more complicated.

In contrast, the present invention directly integrates the lower component container 500 on the bottom border of the outer frame body 110, in other words, the lower component container 500 and the outer frame body 110 are integrated into a whole, so that the design of the present invention has the effect of simple structure and low production cost.

In practice, the lower component container 500 includes a container cover, a container bottom plate 520, and a container sidewall 530, wherein the container bottom plate 520 is integrated in the outer frame body 110, and the container bottom plate 520 is integrated with the outer frame body 110 as a whole.

The container sidewall 530 is disposed around the container bottom plate 520, and the container sidewall 530 is fixedly disposed on the container bottom plate 520, and the container cover 510 is detachably disposed on the container bottom plate 520, so as to form a container cavity 540 around the container cover 510, the container bottom plate 520, and the container sidewall 530.

The LED component unit 541 is disposed in the container cavity 540, and in practice, the LED component unit 541 may include a control module, a power supply module, and other components of the LED display.

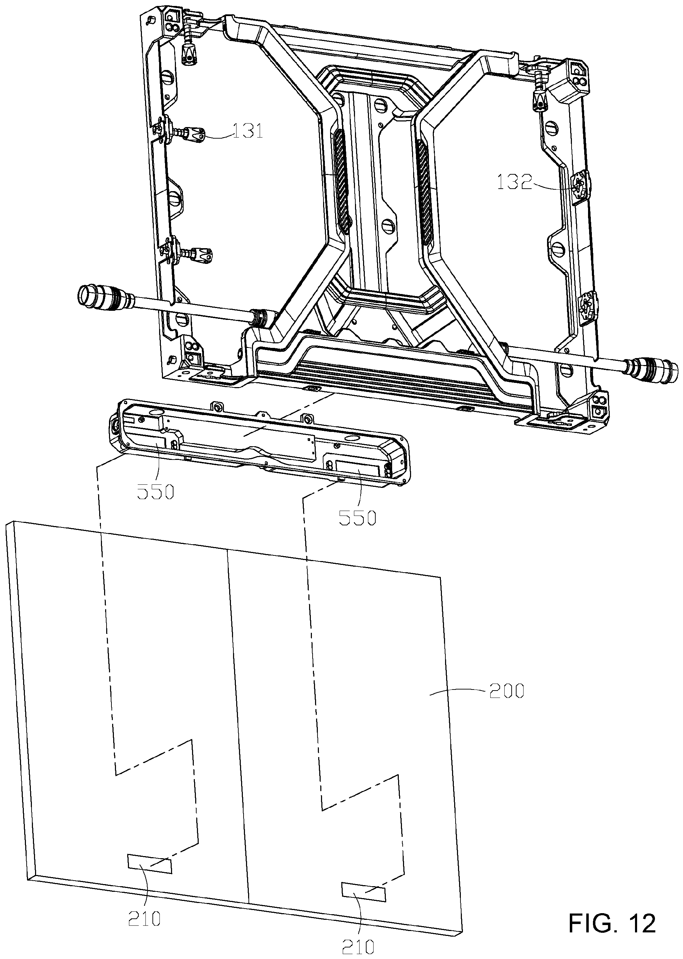

As shown in FIG. 12, a module socket 550 is provided on the container cover 510, and a module plug 210 is provided on the back of the LED display module 200 corresponding to the module socket 550.

When the LED display module 200 is assembled on the front side of the assembling frame 100, the module plug 210 is docked in the module socket 550, and the connection between the LED display module 200 and the LED component unit 541 in the container cavity 540 can be accomplished, and the connection between the LED display module 200 and the LED component unit 541 in the container cavity 540 can be accomplished through the number of the plate holes 122 and the number of the frame holes 112, so that the overall assembling process is simple.

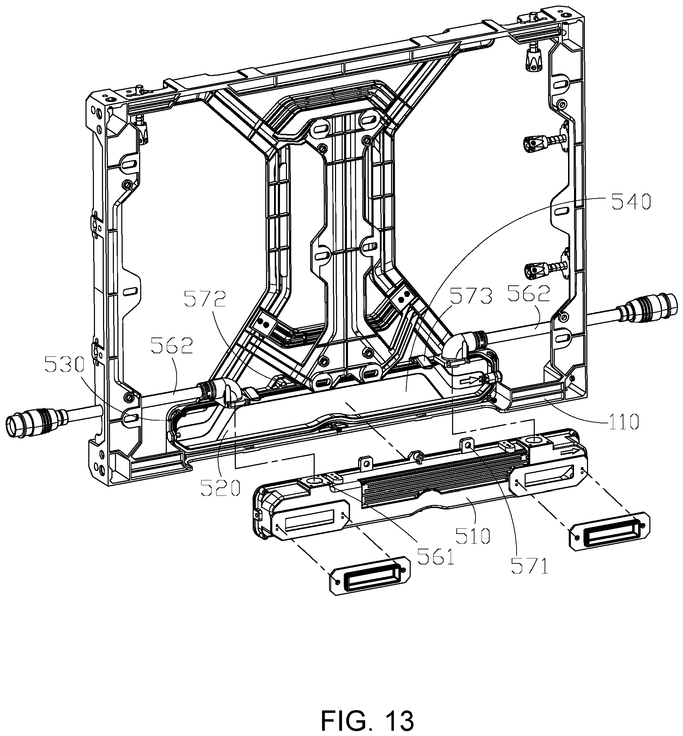

As shown in FIG. 13, the container cover 510 is provided with a wiring hole 561, and the wiring hole 561 is provided with a connecting cable 562, through which the connecting cable 562 is capable of realizing electric power as well as signal connection between two or more of the assembling frames 100.

In practice, the container cover 510 is provided with a container cover positioner 571, and the container bottom plate 520 is provided with a bottom plate positioner 572 corresponding to the container cover positioner 571.

In practice, the container cover positioner 571 is a positioning hole and the bottom plate positioner 572 is a positioning post, and in practice, a fixing buckle 573 is also provided between the container base plate 520 and the container cover 510, so that the container cover 510 can be detachably positioned on the container base plate 520 by the container cover positioner 571, the bottom plate positioner 572, and the fixing buckle 573.

In practice, the LED component unit 541 is directly affixed to the container bottom plate 520, and the heat generated during the work of the LED component unit 541 is conducted to the overall outer frame body 110 by the container bottom plate 520, and the heat is emitted outwardly from the whole outer frame body 110, so as to has an excellent heat dissipation effect.

In practice, the outer frame body 110 and the container bottom plate 520 are formed by the same material in a single process, and the outer frame body 110 and the container bottom plate 520 may be made of metallic aluminum, so as to has the characteristics of light weight and good heat dissipation effect.

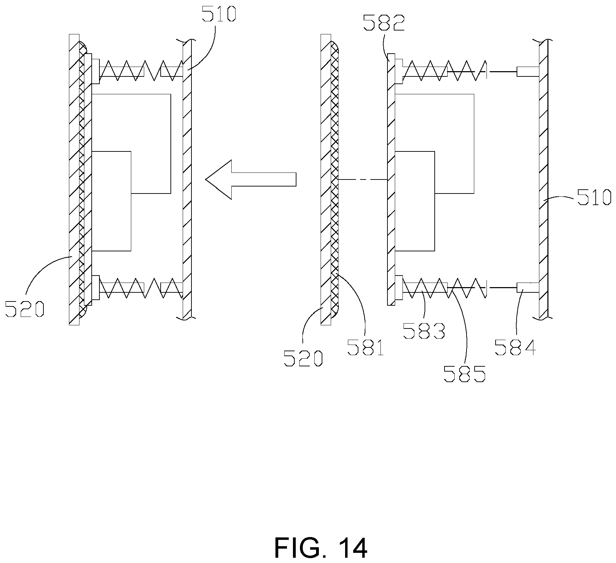

As shown in FIG. 14, in practice, the container bottom plate 520 is provided with a thermal conductive adhesive layer 581.

The container cover 510 also includes an integrated plate 582, a plate body column 583, a cover body column 584, and a spring 585, wherein the LED component unit 541 is centrally disposed on the integrated plate 582, and the plate body columns 583 are disposed at the four corner positions of the integrated plate 582, and the cover body columns 584 are disposed on the container cover 510, and the plate body columns 583 are one-to-one with the cover body columns 584, and the spring 585 is disposed on the plate body column 583 and the cover body column 584, and the integration board 582 is pressed on the thermal conductive adhesive layer 581.

The heat generated by the operation of the LED component unit 541 is conducted to the container bottom plate 520 by the integrated plate 582 and the thermal conductive adhesive layer 581.

When assembling, the LED component unit 541 is first centrally positioned on the integrated plate 582, and then the spring 585 is set on the plate body column 583 and the cover body column 584, and finally, the integrated plate 582 is pressed on the heat-conductive adhesive layer 581 by pressing down on the container cover 510 to complete the assembling, which is a simple assembling manner.

As shown in FIGS. 12 to 13, in practice, the outer frame body 110 is surrounded by an assembling lock, wherein the assembling lock is able to achieve the fixation between two of the assembling frames 100, and in practice, the assembling lock comprises a lock body 131 and a latch 132.

## Claims

1. An assembling frame for an LED display having a lateral width W and a vertical height H,
wherein the lateral width W and the vertical height H have different sizes,
wherein the assembling frame is assembled with an LED display module on the front side, and the LED display module is energized to emit light and display image information,
wherein several of the assembling frames are assembled together to form a large LED display screen,
wherein the large LED display comprises N1 of the assembling frames in lateral, and the number of N1 of the assembling frames in lateral is more than 2,
wherein the large LED display comprises N2 of the assembling frames in vertical, and the number of N2 of the assembling frames in vertical is more than 2,
wherein the several of the assembling frames are formed into the large LED display in a lateral assembling manner or a vertical assembling manner,
wherein when the several of the assembling frames are formed into the large LED display in the lateral assembling manner, the width of the large LED display is the width W times the number of the assembling frames in lateral, and the height of the large LED display is the vertical height H times the number of the assembling frames in vertical,
wherein when the several of the assembling frames are formed into the large LED display in the vertical assembling manner, the width of the large LED display is the height H times the number of the assembling frames in lateral, and the height of the large LED display is the lateral width W times the number of the assembling frames in vertical.

2. An assembling frame for an LED display as recited in claim 1, wherein the assembling frame is provided with a handle unit on the back side of the assembling frame, wherein the handle unit comprises a first handle portion and a second handle portion.

3. An assembling frame of an LED display as recited in claim 2, wherein the second handle portion is connected with the first handle portion to form the handle unit.

4. An assembling frame for an LED display screen as recited in claim 3, wherein the assembling frame includes an outer frame body, wherein the outer frame body has an LED module assembling surface, wherein the LED module assembling surface is disposed at a front end of the outer frame body, and the LED display module is detachably assembled on the LED module assembling surface,
wherein the handle unit is coupled to the outer frame body, a first vertical distance D1 is between the first handle portion and the LED module assembling surface, and a second vertical distance D2 is between the second handle portion and the LED module assembling surface, and the first vertical distance D1 is greater than or equal to the second vertical distance D2, namely D1≥D2.

5. An assembling frame for an LED display as recited in claim 4, wherein the first handle portion includes a left handle and a right handle, wherein the left handle and the right handle both include a first connecting bar and a first handle bar, wherein the first handle bar is connected between two of the first connecting bars, wherein that first connecting bar is tiltedly connected to the outer frame body,
wherein the second handle portion is connected between the left handle and the right handle,
wherein the second handle portion comprises an upper handle and a lower handle, wherein the upper handle and the lower handle both comprise a second connecting bar and a second handle bar, wherein the second handle bar is connected between two of the second connecting bars, wherein the second connecting bar is tiltedly connected to the first connecting bar.

6. An assembling frame for an LED display as recited in claim 4,
wherein the assembling frame further comprises a module assembling plate having an assembling surface overlapping on the LED module assembling surface,
wherein the module assembling plate is coupled to the handle unit such that the module assembling plate is suspended in the outer frame body .

7. An assembling frame for an LED display as recited in claim 6,
wherein the module assembling plate is provided with several connecting claws,
wherein one end of the connecting claw is connected to the module assembling plate, and the other end of the connecting claw is connected to the handle unit, and the module assembling plate is suspended in the center of the outer frame body by several of these connecting claws .

8. An assembling frame for an LED display as recited in claim 6,
wherein several plate holes are provided on the module assembling plate, and several frame holes are provided at the front end of the outer frame body,
wherein several of the plate holes and several of the frame holes are provided on the LED module assembling surface,
wherein the LED display module is detachably assembled on the LED module assembling surface by the several plate holes and the several frame holes .

9. A assembling frame for an LED display as recited in claim 4,
wherein the assembling frame further comprises a lower component container integrally provided in the outer frame body .

10. An assembling frame for an LED display as recited in claim 9,
wherein the lower component container includes a container cover, a container bottom plate, and a container sidewall,
wherein the container bottom plate is integrally disposed in the outer frame body, and the container bottom plate is integrated with the outer frame body as a whole,
wherein the container sidewall is disposed around the container bottom plate, and the container sidewall is fixedly disposed on the container bottom plate,
wherein the container cover is detachably disposed on the container bottom plate, so that a container cavity is formed around the container cover, the container bottom plate, and the container sidewall,
wherein the LED component unit is provided in the container cavity .

11. An assembling frame for an LED display as recited in claim 10,
wherein a module socket is provided on the container cover, and a module plug is provided on the back of the LED display module corresponding to the module socket.

12. An assembling frame for an LED display as recited in claim 10,
wherein the container cover is provided with a wiring hole, and a connection cable is provided through the wiring hole .

13. An assembling frame for an LED display screen as recited in claim 10,
wherein the container cover is provided with a container cover positioner,
and a bottom plate positioner is provided on the container bottom plate opposite to the container cover positioner,
wherein the container cover positioner is a positioning hole, and the bottom plate positioner is a positioning post,
wherein a fixing clasp is also provided between the container bottom plate and the container cover.

14. An assembled container for an LED display as recited in claim 10,
Wherein the LED component unit is directly affixed and fixed to the container bottom plate,
and the heat generated by the operation of the LED component unit is conducted through the container bottom plate to the outer frame body overall, and the heat is emitted outwardly from the outer frame body overall.

15. An assembling frame for an LED display as recited in claim 14,
wherein the container bottom plate is provided with a thermal conductive adhesive layer,
and the container cover further comprising an integration plate, a plate body column, a cover body column, and a spring,
wherein the LED component unit is centrally provided on the integration board,
and the plate column is provided at the corners of the integration board,
and the cover body column is provided on the cover,
and the plate body column corresponds to the cover body column,
and the spring is provided on the plate body column and the cover body column,
and the integration board is pressed on the thermal conductive adhesive layer,
wherein the heat generated by the operation of the LED component unit is conducted to the container bottom plate through the integrated plate and the thermal conductive adhesive layer, and the heat generated by the operation of the LED component unit is transmitted to the container bottom plate .
